Europäisches Patentamt

European Patent Office

Office européen des brevets

(19)

(11) Publication number: 0 335 634
A2

# (12) EUROPEAN PATENT APPLICATION

(21) Application number: 89303003.1

(22) Date of filing: 28.03.89

(51) Int. Cl.4: **H 01 L 23/56**
H 01 L 23/52

(30) Priority: 28.03.88 JP 74002/88

(43) Date of publication of application:
04.10.89 Bulletin 89/40

(84) Designated Contracting States: DE FR GB

(71) Applicant: SEIKO INSTRUMENTS INC.
31-1, Kameido 6-chome Koto-ku
Tokyo 136 (JP)

(72) Inventor: Shimoda, Sadashi
c/o Seiko Instruments Inc. 31-1-Kameido 6-chome
Koto-ku Tokyo (JP)

(74) Representative: Miller, Joseph et al
J. MILLER & CO. Lincoln House 296-302 High Holborn
London WC1V 7JH (GB)

(54) Integrated circuit incorporating a voltage detector circuit.

(57) An integrated circuit incorporating a voltage detector circuit, said voltage detector circuit comprising a voltage input terminal (7) for inputting a voltage to be checked; a reference voltage circuit (1) for providing a reference voltage; resistance means (2) connected to the voltage input terminal (7); a comparator (3) for comparing a voltage at the resistance means (2) with the voltage of the reference voltage circuit (1); and an output terminal (6) connected to the comparator (3) for outputting the result of the comparison characterised at least one part of the resistance means (2) has had its resistance adjusted by means of a laser beam.

Fig. 2

EP 0 335 634 A2

**Description**

### INTEGRATED CIRCUIT INCORPORATING A VOLTAGE DETECTOR CIRCUIT.

This invention concerns an integrated circuit incorporating a voltage detector circuit.

In a prior voltage detector circuit incorporated in an integrated circuit, the voltage detector circuit has comprised a voltage input terminal for inputting a voltage to be checked; a reference voltage circuit for providing a reference voltage; resistance means connected to the voltage input terminal; a comparator for comparing a voltage at the resistance means with the voltage of the reference voltage circuit; and an output terminal connected to the comparator for outputting the result of the comparison.

The resistance of at least one part of the said resistance means of the prior voltage detector circuit has, where necessary, been adjusted by etching but this has not been very satisfactory because it has resulted in a low production yield.

According, therefore, to the present invention, there is provided an integrated circuit incorporating a voltage detector circuit, said voltage detector circuit comprising a voltage input terminal for inputting a voltage to be checked; a reference voltage circuit for providing a reference voltage; resistance means connected to the voltage input terminal; a comparator for comparing a voltage at the resistance means with the voltage of the reference voltage circuit; and an output terminal connected to the comparator for outputting the result of the comparison characterised in that at least one part of the resistance means has had its resistance adjusted by means of a laser beam.

Preferably, the resistance means comprises a plurality of resistors which are connected in series to each other, the resistors also being connected to resistance members at least one of which has been cut by means of a laser beam.

Each of the resistance members may be constituted by a polycrystalline silicon resistor or by an aluminium wire.

The invention is illustrated, merely by way of example, in the accompanying drawings, in which:-

Figure 1 is a circuit diagram of a first embodiment of a resistance means forming part of an integrated circuit incorporating a voltage detector circuit according to the present invention,

Figure 2 is a circuit diagram of a prior voltage detector circuit,

Figure 3 is a circuit diagram of a resistance means forming part of the prior voltage detector circuit of Figure 2, and

Figure 4 is a circuit diagram of a second embodiment of a resistance means forming part of an integrated circuit incorporating a voltage detector circuit according to the present invention.

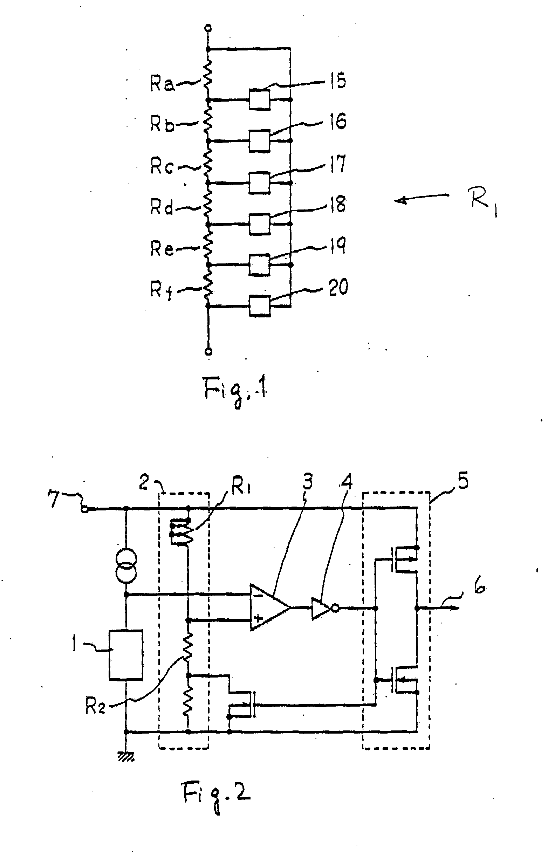

As indicated above, Figure 2 is a circuit diagram of a prior voltage detector circuit. The circuit of Figure 2 comprises a voltage input terminal 7 and a resistance means 2 connected to the voltage input terminal 7. A voltage provided by the resistance means 2 and a voltage provided by a reference voltage circuit 1 are compared by a compartor 3, and the result of the comparison is amplified by an inverter 4 and by an amplifier 5. Therefore when the voltage provided by the resistance means 2 is smaller than the reference voltage, a low voltage is provided at an output terminal 6; and when the voltage provided by the resistance means 2 is larger than the reference voltage, a high voltage is provided at the output terminal 6.

When a voltage detector circuit as described above is fabricated in an integrated circuit (hereinafter called an IC), the following problems occur.

If the voltage at the output terminal 6 when the output changes from a low voltage to a high voltage is called a release voltage $Vdet^+$, the value of the release voltage $Vdet^+$ is given by the equation (1):

$$Vdet = \frac{R_1 + R_2}{R_2} \times Vret \qquad (1)$$

where $R_1$ is the resistance of a resistor $R_1$ forming part of the resistance means 2 shown in Figure 2, $R_2$ is the resistance of a resistor $R_2$ forming another part of the resistance means 2 shown in Figure 2, and Vref is the output voltage of the reference voltage circuit 1.

As will be appreciated from the equation (1), a desired $Vdet^+$ can be obtained by setting $R_1$, $R_2$, and Vref at desired values. However, it is well known that when an IC is fabricated, the absolute values of $R_1$, $R_2$, and Vref deviate substantially from the designed values. This is particular because, when the voltage detector circuit of Figure 2 is fabricated into an IC, the reference voltage Vref of the equation (1) changes considerably and the desired $Vdet^+$ is not obtained. Therefore the value of the resistance $R_1$ of the equation (1) is adjusted to obtain the desired $Vdet^+$.

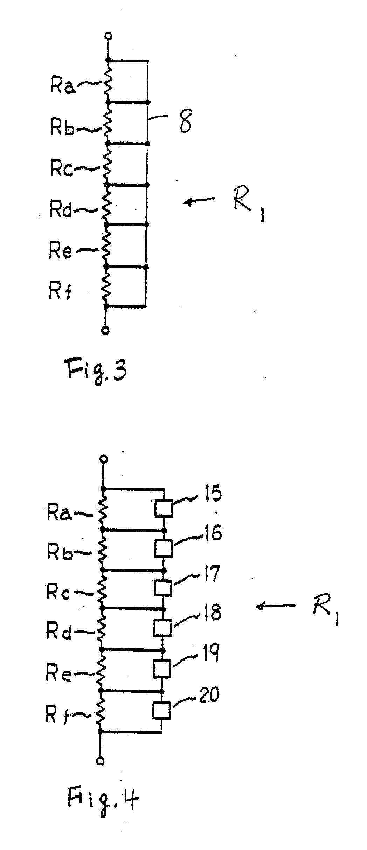

A prior method of trimming the resistor $R_1$ will now be described. Figure 3 is a circuit diagram showing only the resistor $R_1$ of the circuit shown in Figure 2. Resistors Ra, Rb, Rc, Rd, Re and Rf are connected in series with each other, and are also connected to aluminium wirings or resistance members 8 in parallel. After such a reference voltage circuit has been fabricated in an IC process, the reference voltage Vref is measured. The measured value is substituted for Vref in the equation (1), and a resistance ratio $(R_1 + R_2)/R_2$ which gives a desired $Vdet^+$ is calculated. The value of the resistance $R_1$ is calculated from the resistance ratio, and the specification of an aluminium wiring 8 to be cut is decided accordingly. For example, when the resistance $R_1$ is

required to be Re + Rf, portions of the aluminium wirings 8 to be cut are connected in parallel with the resistors Re and Rf are cut by etching. By this means, the resistor $R_1$ is given the value Re + Rf.

However, if the trimming is carried out by the method described above in which aluminium wirings 8 are cut by etching, the resistance value $R_1$ in all the chips of an IC wafer has the value Re + Rf. This has the disadvantage of producing a low production yield. The cause of this problem is that variations in the above method occur even in an IC wafer. For example, the value of $R_1$ on the right hand side of a wafer, which value has been decided on the basis of the value of the reference voltage Vref, may not apply to that on the left hand side thereof.

An object of the present invention is therefore to provide voltage detector circuits which can be fabricated in an IC wafer with a low percentage number of defective circuits.

Accordingly, in the embodiments of the invention described below, and in contrast to effecting adjustments by etching the aluminium wirings, a desired Vdet$^+$ value is obtained by adjusting the resistance value $R_1$ by employing a laser beam to cut only required portions of polycrystalline silicon resistors or aluminium wirings connected to the resistor $R_1$. Such cutting may, for example, be effected by using the laser repairing apparatus M118 of TERADYNE INC.

In Figure 1 there is therefore shown a circuit diagram of a resistor $R_1$ of a voltage detector circuit according to the present invention, the resistor $R_1$ forming part of the circuit shown in Figure 2. The resistor $R_1$, like the resistor $R_1$ of Figure 3, comprises resistors Ra, Rb, Rc, Rd, Re, Rf. Further, respective contact points of the resistors Ra - Rf are connected to respective ends of link members or resistance members 15-20 composed of polycrystalline silicon resistors or aluminium wirings which can be cut by a laser beam.

The trimming method will now be described. A reference voltage Vref of the fabricated reference voltage circuit 1 is measured, the resistance ratio $(R_1 + R_2)/R_2$ which gives a desired Vdet$^+$ is decided according to the equation (1), and the value of the resistor $R_1$ is calculated. The operation so far is the same as that of the prior method described above. For example, if the resistance $R_1$ is required to be Re + Rf, the link members 19 and 20 are cut by a laser beam in the same manner as in the prior method described above. If the resistance values of the respective link members 15-20 are smaller than those of the resistors Ra - Rf, the resistance value of the resistor $R_1$ becomes almost the same as the value of Re + Rf. In practice, the resistance values of Ra - Rf are in the range of between several tens $K\Omega$ and several $M\Omega$, and the resistance values of the link members 15 to 20 are of the order of several tens $\Omega$. In the Figure 1 embodiment described above, polycrystalline silicon resistors are used as the link members 15-20. However, if aluminium link members are used, the resistance value becomes closer to the value of Re + Rf.

By fabricating each chip on an IC wafer in the form applicable to the above trimming method, variations in the reference voltage Vref can be compensated by cutting the link members 15-20 with a laser beam to obtain an appropriate value of $R_1$.

Another embodiment of the present invention is shown in Figure 4. Link members 15-20 are connected in parallel with resistors Ra - Rf. In the same way as in the embodiment of Figure 1, the link members 15-20 which are connected in parallel with the resistors Ra-Rf are adjusted to give the required resistance value by means of cutting with a laser beam.

In the embodiments of the present invention described above, the link members 15-20 which are connected to the resistors Ra-Rf are cut by a laser beam at portions defined by the value of the reference voltage, thereby obtaining a desired Vdet$^+$. Adjustment of each chip in this manner effects an improvement in the productivity of voltage detector integrated circuit devices.

## Claims

1. An integrated circuit incorporating a voltage detector circuit, said voltage detector circuit comprising a voltage input terminal (7) for inputting a voltage to be checked; a reference voltage circuit (1) for providing a reference voltage; resistance means (2) connected to the voltage input terminal (7); a comparator (3) for comparing a voltage at the resistance means (2) with the voltage of the reference voltage circuit (1); and an output terminal (6) connected to the comparator (3) for outputting the result of the comparison characterised in that at least one part of the resistance means (2) has had its resistance adjusted by means of a laser beam.

2. An integrated circuit as claimed in claim 1 characterised in that the resistance means (2) comprises a plurality of resistors (Ra, Rb, Rc, Rd, Re, Rf) which are connected in series to each other, the resistors (Ra, Rb, Rc, Rd, Re, Rf) also being connected to resistance members (15-20) at least one of which has been cut by means of a laser beam.

3. An integrated circuit as claimed in claim 2 characterised in taht each of the resistance members (15-20) is constituted by a polycrystalline silicon resistor or by an aluminium wire.

4. An integrated circuit as claimed in claim 2 or 3 characterised in that the resistance membes (15-20) are connected in parallel with the resistors (Ra-Rf).

5. A voltage detector circuit fabricated in an integrated circuit, said voltage detector circuit comprising:
a voltage input terminal (7) for inputting a voltage to be checked;
a reference voltage circuit (1) for providing a reference voltage;
resistors (2) for providing a part of said inputted voltage which is compared with said reference voltage;

a plurality of members (15-20) connected to said resistors (2), all of or a part of said members (15-20) being cut by a laser beam according to a reference voltage provided by said reference voltage circuit (7);

a comparator (3) for comparing said voltages provided by said reference voltage circuit (1) and said resistors (2) and

an output terminal (6) for outputting the comparison result of said comparator.

Fig. 1

Fig. 2

Fig. 3

Fig. 4